# EUROPÄISCHE PATENTSCHRIFT

(11) **EP 0 324 441 B1**
(45) Veröffentlichungstag und Bekanntmachung des Hinweises auf die Patenterteilung: **02.06.1993**
(21) Anmeldenummer: 89100357.6
(22) Anmeldetag: 10.01.1989
(51) Int. Cl.: H05K 13/04

(54) **Einrichtung zum dosierten Auftragen von Klebstoff**
Apparatus for the dosed application of an adhesive
Dispositif pour l'application dosable d'adhésif

(30) Priorität: 11.01.1988 DE 3800518; 10.08.1988 DE 3827151
(43) Veröffentlichungstag der Anmeldung: 19.07.1989
(73) Patentinhaber: SIEMENS AKTIENGESELLSCHAFT, 80333 München (DE)
(72) Erfinder: Schally, Thomas, Dipl.-Ing. (FH), D-8124 Seeshaupt (DE); Martin, Bernhard, Dipl.-Ing. (FH/Univ), D-8031 Wessling (DE); Freytag, Hans Peter, D-8000 München 40 (DE); Hagn, Gerald, D-8000 München 2 (DE)

(56) Entgegenhaltungen:
- DE-A- 3 435 507
- US-A- 4 572 103

## Beschreibung

Die Erfindung betrifft eine Einrichtung zum dosierten Auftragen von Klebstoff nach dem Oberbegriff des Patentanspruches 1.

Eine derartige Einrichtung, die speziell für das dosierte Auftragen von Lötmittel entwickelt wurde, aber auch für das dosierte Auftragen von Klebstoff geeignet ist, ist aus der US-A-4 572 103 bekannt.

Bei der automatischen Bestückung von Leiterplatten mit SMD-Bausteinen für die Oberflächen-Montage (SNMD = Surface Mounted Devices) werden durch eine in einem Dosierkopf einer Positioniereinheit angeordnete Dosiervorrichtung zunächst Klebstoff-Tropfen aufgebracht, auf die die SMD-Bausteine dann aufgesetzt werden. Der Klebstoff härtet dann beispielsweise durch die Einwirkung von Wärme oder UV-Strahlung aus. Die SMD-Bausteine sind danach in der richtigen Lage so fest auf der Leiterplatte fixiert, daß die elektrische Verbindung im Schwallbad durch Reflow-Löten oder durch Löten in der Dampf-Phase hergestellt werden kann. Die für die Klebstoff-Applikation in bekannter Weise eingesetzten Dosiervorrichtungen bestehen im wesentlichen aus einer mit Druckluft beaufschlagbaren Klebstoff-Kartusche, einer in die Klebstoff-Kartusche eingesetzten Dosiernadel und gegebenenfalls einem der Dosiernadel zugeordneten Abstandshalter. Zum Aufbringen eines Klebstoff-Tropfens wird die in der Positioniereinheit eines SMD-Bestückungsautomaten angeordnete Dosiervorrichtung abgesenkt, bis der Abstandshalter auf der Leiterplatte aufsitzt.

Aus der sich in dieser ab gesenkten Stellung knapp oberhalb der Leiterplatte befindlichen Austrittsöffnung der Dosiernadel wird dann durch Druckluftbeaufschlagung der Klebstoff-Kartusche ein Klebstoff-Tropfen auf die Leiterplatte gepreßt, wobei die aufdosierte Klebstoffmenge von der Dosierzeit, vom Druck mit dem die Klebstoff-Kartusche beaufschlagt wird, von der Nadelgeometrie und der Viskosität des Klebstoffes abhängt. Im Zusammenhang mit der Nadelgeometrie ist insbesondere die Länge der rohrförmigen Dosiernadel von Bedeutung, die linear in die die aufdosierte Klebstoffmenge definierende Formel eingeht.

Die Volumenkonstanz bei der Klebstoffdosierung hängt wesentlich von der Klebstofftemperatur innerhalb der Dosiernadel ab. Es wurde daher bereits eine die Dosiernadel umgebende Klimakammer geschaffen, durch die die Temperatur des Klebstoffes im Bereich der Austrittsöffnung oder Dosiernadel konstant gehalten wird. Hierzu durchströmt bekannterweise ein geringer Druckluftstrom, der mit Hilfe eines Peltier-Elementes oder dergleichen auf eine konstante Temperatur erhitzt oder gekühlt wird, die Klimakammer. Der Ist-Wert der Temperatur wird am Mantel der Klimakammer gemessen und über einen Regelkreis auf einen vorgegebenen Soll-Wert geregelt.

Ein Problem der zuvor beschriebenen bekannten Einrichtung zum dosierten Auftragen von Klebstoff besteht darin, daß ein Wechsel der aus einer Kartusche und einer Dosiernadel bestehenden Dosiervorrichtung, wie er beispielsweise erforderlich ist, wenn eine andere Dosiermenge aus einer anders bemessenen Dosiernadel abgegeben werden soll, sehr viel Zeit erfordert. Unterschiedliche Dosiermengen sind beispielsweise zur Fixierung unterschiedlich großer Bauelemente auf ein und derselben Leiterplatte erwünscht. Für die Fixierung von Bauelementen unterschiedlicher Größen können beispielsweise Dosiermengen erwünscht sein, die sich um den Faktor 50 oder mehr unterscheiden.

Die Aufgabe der vorliegenden Erfindung besteht daher darin, eine Einrichtung zum dosierten Auftragen von Klebstoff anzugeben, mit deren Hilfe ein einfacher Wechsel der Dosiervorrichtung möglich ist.

Diese Aufgabe wird durch eine wie eingangs bereits genannte Einrichtung zum dosierten Auftragen von Klebstoff gelöst, die durch die in dem kennzeichnenden Teil des Patentanspruches 1 angegebenen Merkmale gekennzeichnet ist.

Ein wesentlicher Voirteil der Erfindung besteht darin, daß erstmals ein automatischer Wechsel von Dosiervorrichtungen ermöglicht wird, ohne daß manuelle Handgriffe erforderlich sind. Da bei dem automatischen Wechsel von Dosiervorrichtungen kaum Zeit verloren geht, können unnötige und kostenaufwendige Standzeiten der Bestückungsautomaten in vorteilhafter Weise vermieden werden.

Vorteilhafte Ausgestaltungen der Erfindung, die auch eine bevorzugte Justiervorrichtung und eine bevorzugte Temperiervorrichtung umfassen, gehen aus den Unteransprüchen 2 bis 16 hervor.

Im Folgenden werden die Erfindung und deren Ausgestaltungen im Zusammenhang mit den Figuren näher erläutert. Es zeigt:
- Fig. 1: in schematischer Darstellung einen SMD-Bestückungsautomaten;
- Fig. 2: in schematischer Darstellung eine im Zusammenhang mit der vorliegenden Einrichtung verwendete Dosiervorrichtung;
- Fig. 3 bis 5: verschiedene Ansichten einer Halterung für die Dosiervorrichtung der Fig. 2, wobei die Halterung Bestandteil des Dosierkopfes ist; und
- Fig. 6 bis 9: verschiedene Ansichten von die Düse aufnehmenden Stiften des Dosierkopfes bzw. einer Halteeinrichtung der Wartestation.
- Fig. 10a bis. e, 11 und 12: Weiterbildungen der Erfindung

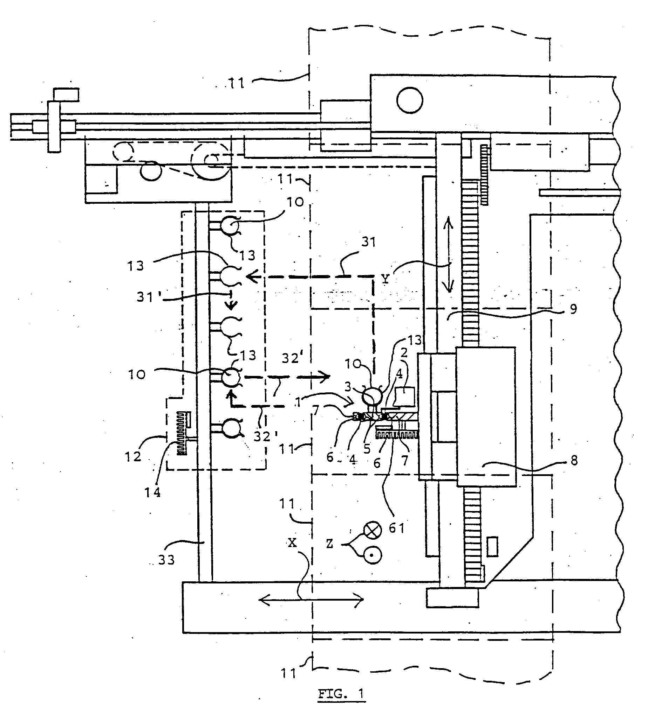

Im Folgenden wird zunächst ein SMD-Bestückungsautomat im Zusammenhang mit der Fig. 1 erläutert, in dem die vorliegende Einrichtung bevorzugt verwendet wird. In der Fig. 1 ist der Dosierkopf des Bestückungsautomaten mit 1 bezeichnet. Der Dosierkopf 1 ist durch eine schematisch dargestellte Hub-und Absenkeinrichtung 2 in der Richtung senkrecht zur Zeichenebene (Z-Achse) bewegbar. Um eine besonders reibungsfreie Bewegung zu ermöglichen, weist der Dosierkopf 1 vorzugsweise einen block- oder plattenförmigen Hubschlitten 3 auf, der sich in der Richtung der Z-Achse erstreckt und an dessen gegenüberliegenden Längskanten halbkreisförmige Längsnuten 5 vorgesehen sind, in die Kugeln 4 eingreifen, die in entsprechenden Vertiefungen 6 eines den Hubschlitten 3 umgebenden Rahmens 7 oder dergleichen gehalten werden. An der Stelle der Kugeln 4 können auch andere Wälzlager Verwendung finden. Die Längsnut 5 kann auch am Rahmen 7 vorgesehen werden, wenn die Vertiefungen in dem Hubschlitten 3 angeordnet sind. Der Dosierkopf 1 ist an einem Schlitten 8 befestigt, der in an sich bekannter Weise durch einen Antrieb entlang einer Führungsschiene 9 oder dergleichen bewegbar ist. Die Führungsschiene 9 verläuft entlang der Y-Achse. Durch einen weiteren Antrieb ist die gesamte Führungsschiene 9 in an sich bekannter Weise entlang der sich senkrecht zur Y-Achse erstreckenden X-Achse bewegbar.

Der Dosierkopf 1, die Führungsschiene 9 und der Schlitten 8 sowie die entsprechenden Antriebe sind Teil der Positioniereinheit.

Auf diese Weise kann die in dem Dosierkopf 1 befestigte Dosiervorrichtung 10 durch Bewegen des Schlittens 8 und der Führungsschiene 9 in der X- und Y-Richtung zu jedem beliebigen Ort einer unterhalb des Dosierkopfes 1 angeordneten Leiterplatte 11 bewegt werden. Beispielsweise werden die Leiterplatten 11 in der Y-Richtung dem Bestückungsautomaten zugeführt.

Ein wesentlicher Bestandteil der vorliegenden Einrichtung ist die in der Fig. 1 schematisch durch das Bezugszeichen 12 dargestellte Wartestation, in der unterschiedliche Dosiervorrichtungen 10 derart in Halterungen 13 gehalten werden, daß sie in der später näher erläuterten Weise automatisch in eine Halteeinrichtung des Dosierkopfes 1 übernommen und aus der Halteeinrichtung des Dosierkopfes 1 in die Halteeinrichtungen der Wartestation 12 abgegeben werden können.

Die Wartestation 12 umfaßt vorzugsweise eine Temperiereinrichtung 14, durch die der Klebstoff der in der Wartestation 12 befindlichen Dosiervorrichtungen 10 wenigstens im Bereich der Düse 23 auf einer vorgegebenen Temperatur gehalten werden kann, die für das Aufbringen definierter Klebstoffmengen bei den Setzoperationen optimal ist. Vorzugsweise wird der Wartestation 12 durch die Temperiereinrichtung 14 in der später noch näher erläuterten Weise temperierte Luft zugeführt, die die vorgegebene Temperatur besitzt.

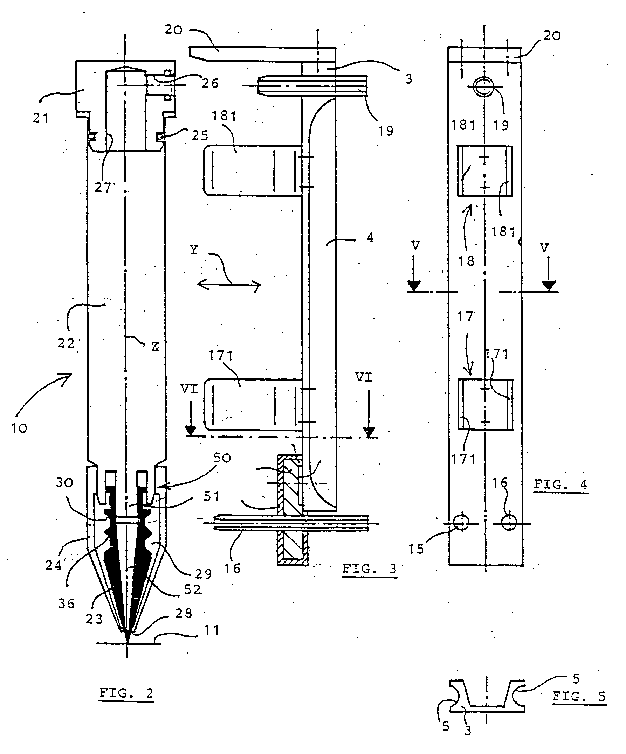

Im Folgenden wird nun im Zusammenhang mit der Fig. 2 der Aufbau einer bei der vorliegenden Einrichtung verwendeten Dosiervorrichtung 10 näher erläutert. Einzelheiten der Fig. 2, die bereits im Zusammenhang mit der Fig. 1 beschrieben wurden, sind in der entsprechenden Weise bezeichnet. Die Dosiervorrichtung 10 besteht im wesentlichen aus einer Klebstoff-Kartusche 22, deren oberes Ende durch einen Stopfen 21 oder dergleichen verschlossen ist, einer Düse 23, die an dem unteren Ende der Klebstoff-Kartusche 22 befestigbar ist und durch deren Abgabeöffnung 28 der Klebstoff abgegeben wird, und einer Isolierhülle 24, die die Düse 23 derart konzentrisch umgibt, daß zwischen der Düse 23 und der Isolierhülle 24 eine Klimakammer 29 besteht. Der Klimakammer 29 wird in der später noch näher erläuterten Weise temperierte Luft von der Temperiereinrichtung 14 oder einer Temperiereinrichtung 61 des Dosierkopfes 1 zugeführt. Dadurch wird erreicht, daß der in der Düse 23 befindliche Klebstoff auf einer vorgegebenen Temperatur gehalten wird. Eine Dichtung zwischen dem Stopfen 21 und dem oberen Ende der Klebstoff-Kartusche 22 wird vorzugsweise durch eine, in einer entsprechenden Nut des Stopfens 21 vorgesehene O-Dichtung 25 erreicht, die an dem Boden der genannten Nut und an dem Innenumfang der Kartusche 22 anliegt, wenn der Stopfen 21 in das obere Ende der Kartusche 22 eingesetzt ist.

Der Dosierkopf 1 weist an dem Hubschlitten 3 voneinander beabstandete Halterungen 17, 18 auf, in denen die Klebstoff-Kartusche 22 lösbar aufgenommen werden kann. Vorzugsweise bestehen die Halterungen 17, 18 aus voneinander beabstandeten federnden Schenkeln 171 bzw. 181, die so ausgestaltet sind, daß die Kartusche 22 durch die Öffnung zwischen den freien Enden der Schenkel 171 bzw. 181 einschiebbar ist und daß die Schenkel 171 bzw. 181 federnd an einem Teilbereich des Umfanges der Kartusche 22 anliegen, wenn diese in die Halterungen 17 bzw. 18 eingeschoben ist.

Vorzugsweise weist die Kartusche 22, die zweckmäßigerweise aus einem Kunststoffmaterial besteht, einen kreisförmigen Querschnitt auf. In diesem Fall sind die Schenkel 171 bzw. 181 ebenfalls kreisförmig gekrümmt.

An dem Hubschlitten 3 ist außerdem ein Druckluftanschluß 19 befestigt, der die Form eines Rohres aufweist, das dann, wenn die Kartusche 22 in die Halterungen 17, 18 eingesetzt ist, in eine Aufnahmebohrung 26 dicht eingreift. Die Aufnahmebohrung 26, die senkrecht zur Längsachse der Kartusche 22 verläuft und sich im Stopfen 21 befindet, steht über eine weitere Bohrung 27 des Stopfens 21 mit dem Inneren der Kartusche 22 in Verbindung. Über den mit einem nicht dargestellten Schlauch oder dergleichen verbundenen Druckluftanschluß 19 und die Bohrungen 26 und 27 ist in der Kartusche 22 befindlicher Klebstoff mit Druckluft beaufschlagbar. Um zu verhindern, daß die bei der Druckluftbeaufschlagung entstehenden Kräfte eine Verschiebung des Stopfens 21 nach oben bewirken, weist der Hubschlitten 3 an seinem oberen Ende einen Stab oder plattenförmigen Anschlag 20 auf, der an der oberen Endfläche des Stopfens 21 anliegt, wenn der Druckluftanschlag 19 in die Aufnahmebohrung 26 eingreift. Vorzugsweise weist der Anschlag 20 an seinem freien Ende eine Einfahrschräge für die Kante des Stopfens 21 auf.

Am unteren Ende des Hubschlittens 3 sind voneinander beabstandete Stifte 15, 16 (Fig. 4) angeordnet und vorzugsweise in der Y-Richtung ausgerichtet, deren einander zugewandte Seitenflächen in eine Umfangsnut 30 der Düse 23 eingreifen, wenn die Dosiervorrichtung 10 an dem Hubschlitten 3 befestigt ist.

Durch das Eingreifen der Stifte 15 und 16 in die Umfangsnut 30 der Düse 23 wird die eigentliche genaue Positionierung der Düse 23 in Bezug auf den Dosierkopf 1, und zwar in der X-, Y- und Z-Richtung erreicht. Dies wird später noch ausführlicher erläutert werden.

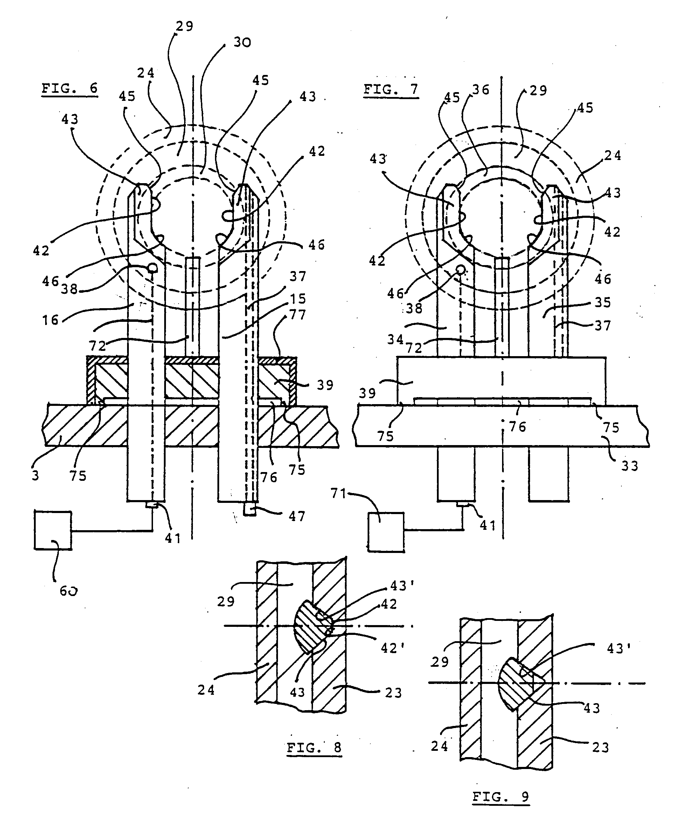

In der Wartestation 12 befinden sich an einer Schiene 33 oder dergleichen Halteeinrichtungen 13, die voneinander vorzugsweise in Y-Richtung beabstandet sind und einzelne Dosiervorrichtungen 10 aufnehmen können. Die Halteeinrichtungen 13 an der Schiene 33 sind etwa so ausgebildet, wie die bereits im Zusammenhang mit den Fig. 3 und 4 beschriebene Halteeinrichtung. Dies bedeutet, daß jede Halteeinrichtung 13 vorzugsweise in der Z-Richtung voneinander beabstandete obere und untere Halterungen aufweist, die den Halterungen 17 und 18 der Fig. 3 und 4 an dem Hubschlitten 3 entsprechen. Unterhalb der unteren Halterung jeder Halteeinrichtung 13 befinden sich voneinander beabstandete Stifte 34, 35 (Fig. 7), die den Stiften 15 und 16 des Hubschlittens 3 entsprechen, vorzugsweise jedoch in der X-Richtung verlaufen. Die Stifte 34 und 35 sind gegenüber den Stiften 15 und 16 in der Richtung der Z-Achse versetzt. Dementsprechend weist die Düse 23 oberhalb oder unterhalb der Umfangsnut 30 eine weitere Umfangsnut 36 auf, die vorzugsweise ähnlich wie die Umfangsnut 30 ausgebildet ist und in die die Stifte 34 und 35 eingreifen, wenn die Dosiervorrichtung 10 in eine Halteeinrichtung 13 der Wartestation 12 eingesetzt ist. Die Halterungen der Halteeinrichtungen 13 der Wartestation 12 sind gegenüber den Halterungen 17 und 18 des Hubschlittens 3 in der Richtung der Z-Achse nach oben oder unten versetzt, so daß sich die Halterungen bei der Entnahme einer Dosiervorrichtung 10 aus einer Halteeinrichtung 13 der Wartestation 12 oder beim Zurückführen einer Dosiervorrichtung 10 in eine Halteeinrichtung 13 der Wartestation nicht gegenseitig stören. Dadurch, daß die Stifte 15, 16 des Hubschlittens 3 und die Stifte 34, 35 der Halteeinrichtungen 13 der Wartestation sowie die Öffnungen der Halterungen 17, 18 der Halteeinrichtung des Hubschlittens 3 und die Öffnungen der Halterungen der Halteeinrichtungen 13 gegeneinander um 90° versetzt sind bzw. in um 90° versetzte Richtungen weisen, und daß die Halterungen der Halteeinrichtungen 13 und die Halterungen 17, 18 in der Z-Richtung gegeneinander versetzt sind, ist eine besonders einfache Übergabe von Dosiereinrichtungen 10 aus dem Dosierkopf 1 in Halteeinrichtungen 13 der Wartestation 12 und umgekehrt möglich.

Im folgenden wird dies kurz erläutert. Wie dies eingangs bereits erwähnt wurde, können sich die Düsen 23 der in der Wartestation 12 befindlichen Dosiervorrichtungen 10 derart im Hinblick auf ihre Abmessungen unterscheiden, daß mit unterschiedlichen Dosiervorrichtungen Klebstoffmengen aufgebracht werden können, die sich beispielsweise um den Faktor 50 unterscheiden. Dies kann für die Fixierung von Bauelementen unterschiedlicher Größen auf einer Leiterplatte 11 wünschenswert sein. Durch den in der Y-Richtung bewegbaren Schlitten 8 und die in der X-Richtung bewegbare Führungsschiene 9 kann der Hubschlitten 3 in den Richtungen X und Y bewegt werden. Es wird zunächst davon ausgegangen, daß sich in der Halteeinrichtung des Hubschlittens 3 eine Dosiervorrichtung 10 befindet. Durch eine gezielte Bewegung des Hubschlittens 3 in der X- und Y-Richtung kann nun jede beliebige Halteeinrichtung 13 der Wartestation 12 angefahren werden. Beispielsweise kann die in der Halteeinrichtung des Hubschlittens 3 befindliche Dosiervorrichtung 10 so bewegt werden, daß in der Fig. 1 die zweite Halteeinrichtung 13 der Wartestation 12 von oben, in der sich keine Dosiereinrichtung 10 befindet, entlang des Weges 31, angefahren wird. Wenn die in der Halteeinrichtung des Hubschlittens 3 befindliche Dosiervorrichtung 10 in der X-Richtung an die genannte Halteeinrichtung 13 der Wartestation 12 angenähert wird, greifen schließlich die Halterungen der Halteeinrichtung 13 an der Klebstoff-Kartusche 22 der Dosiervorrichtung 10 an und werden die Stifte 34 und 35 der Halteeinrichtung 13 in die entsprechende Umfangsnut 36 der Düse 23 der Dosiervorrichtung 10 eingeführt. Dabei werden die Stifte 34, 35 durch entsprechende Öffnungen der Isolierhülle 24 hindurchgeführt. Wenn die Dosiervorrichtung 10 in der X-Richtung völlig in die Halteeinrichtung 13 eingeschoben ist, umschliessen die Halterungen 13 die Kartusche 22 derart, daß beim Entfernen der Halteeinrichtung des Hubschlittens 3 von der Halteeinrichtung 13 in der Y-Richtung, d.h. in der Fig. 1 nach unten (Weg 31'), die Dosiervorrichtung 10 sicher in der Halteeinrichtung 13 der Wartestation 12 festgehalten wird. In der entsprechenden Weise kann dann durch Anfahren einer bestückten Halteeinrichtung 13 durch den nicht bestückten Dosierkopf 1 (z.B. Weg 32) die in dieser Halteeinrichtung 13 befindliche Dosiervorrichtung 10 in die Halteeinrichtung des Hubschlittens 3 übernommen werden, wobei der Dosierkopf 1 danach von der Halteeinrichtung 13 in der X-Richtung (Weg 32') entfernt wird. Der Hubschlitten 3 kann dann durch Verschieben des Schlittens 8 und der Führungsschiene in der X- und Y-Richtung über jeden für eine Klebstoffabgabe gewünschten Ort der Leiterplatte 11 gebracht werden. Durch die Hub- und Absenkeinrichtung 2 kann die Düse 23 dann durch Bewegen des Hubschlittens 3 in der Z-Achse in den für die Klebstoffabgabe geforderten Abstand zur Leiterplatte gefahren werden.

Im Folgenden wird nun im Zusammenhang mit den Fig. 6 bis 8 die spezielle Ausgestaltung der Umfangsnuten 30 und 36 sowie der Stifte 15 und 16 bzw. 34 und 35 näher erläutert. Wie dies schon angedeutet wurde, sind die genannten Umfangsnuten und Stifte so ausgestaltet, daß bei der Aufnahme einer Düse 23 durch ein Stiftepaar eine automatische Justierung der Düse 23 in der X-, Y- und Z-Richtung erfolgt. Zudem ist, wie dies ebenfalls bereits angedeutet wurde, jeweils ein Stift eines Stiftepaares 15, 16 bzw. 34, 35 vorzugsweise hohl ausgebildet (Hohlraum 37), so daß durch ihn temperierte Luft in den Raum bzw. in die Klimakammer 29 zwischen dem Umfang der Düse 23 und der Innenwandung der Isolierhülle 24 eingeführt werden kann. Der jeweils andere Stift des Stiftepaares 15, 16 bzw. 34, 35 weist an seinem freien Endbereich vorzugsweise einen Meßfühler 38 auf, mit dem die Temperatur in der angesprochenen Klimakammer 29 gemessen werden kann. Über eine geeignete Elektronik 60 kann die Temperatur in der Klimakammer 29 durch einen einfachen Regelkreis auf einem gewünschten vorgegebenen Sollwert durch Erwärmen oder Kühlen gehalten werden.

Die den freien Enden gegenüberliegenden Enden der Stifte 15, 16 bzw. 34, 35 sind vorzugsweise in einen Isolierblock 39 eingebettet, der aus einem Kunststoffmaterial, vorzugsweise aus Kufalite® besteht Dieser Isolierblock 39 ist an dem Hubschlitten 3 bzw. an der Schiene 33 befestigt. Der Stift 15 bzw. 35 weist einen Luftzufuhrstutzen 47 auf, der mit dem Hohlraum 37 in Verbindung steht und mit einer Heiz- bzw. Kühlquelle verbunden ist. Bei dieser Quelle kann es sich um die bereits erwähnte Temperierung 14 der Wartestation 12, die z.B. über einen Durchgang in der Schiene 33 mit den Hohlräumen 37 der einen Stifte 35 der Halteeinrichtungen 13 verbunden ist, oder um eine weitere Temperiereinrichtung 61 am Dosierkopf 1 handeln, die über einen Schlauch oder dergleichen mit dem Hohlraum 37 des einen Stiftes 15 des Dosierkopfes 1 verbunden ist. Vorzugsweise weist der Stift 16 bzw. 34 einen elektrischen Steckverbinder 41 oder dergleichen auf, der zur Verbindung des Meßfühlers 38 mit einer elektronischen Einrichtung 60 bzw. 71 dient, die die tatsächlich ermittelte Temperatur auf die vorgegebene Temperatur regelt. Der Isolierblock 39 ist zweckmäßigerweise so gestaltet, daß er zur Erzielung einer besonders guten Isolierwirkung nur über möglichst kleine Auflageflächen 75 am Hubschlitten 3 bzw. an der Schiene 33 anliegt. Zur weiteren Isolierung kann die Auflagefläche 75 einen Hohlraum 76 ringförmig umschließen, wobei die Luft im Hohlraum 76 zwischen dem Isolierblock 39 und dem Hubschlitten 3 oder der Schiene 33 eine zusätzliche Isolierwirkung entfaltet.

Im vorderen Endbereich weisen die Stifte 15, 16 bzw. 34, 35 an den einander zugewandten Innenkanten vorzugsweise eine sich in der Z-Richtung erstreckende ebene Längskante 42 auf, deren Abmessung in der Z-Richtung im wesentlichen der Abmessung des Bodens 42' der Umfangsnut 30 bzw. 36 entspricht (Fig. 8). Ausgehend von den Enden der Längskante 42 in der Z-Richtung gesehen weisen die Stifte 15, 16 bzw. 34, 35 schräg nach oben bzw. schräg nach unten verlaufende Seitenflächen 43 auf, die im Hinblick auf ihre Neigungen der oberen bzw. unteren Seitenflächen 43' der Umfangsnut 30 bzw. 36 entsprechen. Der Abstand zwischen den Längskanten 42 der sich gegenüberliegenden Stifte 15, 16 bzw. 34, 35 entspricht im wesentlichen dem Außenumfang der Düse 23 im Bereich des Bodens 42' der Umfangsnut 30 bzw. 36. Vorzugsweise weisen die schrägen Seitenflächen 43 der Stifte 15, 16 bzw. 34, 35 und die schrägen Seitenflächen 43' der Umfangsnuten 30 bzw. 36 zur Längskante 42 bzw. zum Boden 42' der Nut 30 bzw. 36 die gleichen Winkel auf. Durch die komplementäre Ausgestaltung der einander gegenüberliegenden Endbereiche der Stifte 15, 16 bzw. 34, 35 und der Umfangsnut 30 bzw. 36 und die genannte Dimensionierung des Abstandes der Längskanten 42 voneinander, wird erreicht, daß nach dem Einschieben einer Düse 23 in den Bereich zwischen die genannten Endbereiche eine automatische Ausrichtung der Düse 23 in Bezug auf die Stifte 15, 16 sowohl in der Z- als auch in der X-Richtung bzw. in Bezug auf die Stifte 34, 35 in der Z- und Y-Richtung erfolgt. Diese Ausrichtung kann auch dann besonders einfach erreicht werden, wenn die komplementär zur V-förmigen Umfangsnut 30 bzw. 36 ausgebildeten Stifte 15, 16 bzw. 34, 35 nur an den Seitenflächen der Umfangsnuten anliegen (Fig.9). Um ein leichteres Einfädeln der Düse 23 in den Raum zwischen den genannten Endbereichen zu ermöglichen, können an den Enden der Stifte 15, 16 bzw. 34, 35 Einfahrschrägen 45 vorgesehen sein.

Um eine Justierung der Düse 23 auch in der Einschubrichtung (Y-Richtung für die Halteeinrichtung an der Hubplatte 3; X-Richtung für die Halteeinrichtung an der Wartestation 12) zu ermöglichen, weisen die genannten Endbereiche der Stifte 15, 16 bzw. 34, 35 an ihrem dem Isolierblock 39 zugewandten Bereich zweckmäßigerweise einen Anschlag 46 auf. Dieser Anschlag 46 kann durch ein Stiftelement 72 gebildet sein, das zwischen den Stiften 15, 16 bzw. 34, 35 und parallel zu diesen verläuft. Vorzugsweise verlaufen diese Stiftelemente mittig zwischen den genannten Stiften 15, 16 bzw. 34, 35. Ihre einen Enden sind zweckmäßigerweise ebenfalls in den Isolierblock 39 eingebettet. Der Anschlag 46 kann auch dadurch gebildet sein, daß die einander gegenüberliegenden Längskanten 42 der oben erwähnten Ausführungsform in einen Bereich übergehen, in dem sie sich entsprechend dem Durchmesser des Außenumfanges des Bodens 42' der Umfangsnut 30 bzw. 36 aufeinander zu verengen. Vorzugsweise grenzen auch in den sich verengenden Bereichen 46 an die gekrümmten Längskanten die schrägen Seitenflächen 43 an.

Vorzugsweise sind die Stifte 15, 16 bzw. 34, 35 eines Stiftepaares so ausgestaltet, daß sie in ihrer Querrichtung derart aufeinander zu federn, daß zwischen den Stiften eines Stiftepaares und der Düse 23 Spielfreiheit gewährleistet wird, um eine exakte Justierung der Düse in Bezug auf den Dosierkopf 1 zu erreichen.

Die Düse 23 ist zweckmäßigerweise durch eine Stütz- oder Schraubverbindung 50 an der Kartusche 22 befestibar. Vorzugsweise reicht im befestigten Zustand ein Abgabestutzen 51 der Kartusche 22 dicht in den Innenhohlraum 52 der Düse 23 hinein. Der Innenhohlraum 52 ist vorzugsweise so beschaffen, daß er im Bereich zwischen dem freien Ende des Stutzens 51 und der Abgabeöffnung 28 eine konische Verjüngung aufweist.

Um eine noch bessere Isolierung durch den Isolierblock 39 zu erreichen, kann wenigstens auf die freiliegende Oberfläche desselben eine Isolierschicht 77 aufgebracht werden, die vorzugsweise aus einem Schaumstoffmaterial besteht.

Es wird darauf hingewiesen, daß bei der vorliegenden Erfindung an der Stelle der bekannten Dosiernadel, bei der es sich um ein Wegwerfteil handelt, eine Präzisionsdüse in der Form eines einfachen, harten und formgenauen Drehteiles vorzugsweise verwendet wird. Diese Düse ist vorteilhafterweise wiederverwendbar und leicht zu reinigen.

Die Justierung der Dosiervorrichtung 10 an dem Dosierkopf 1 bzw. an den Halteeinrichtungen der Wartestation 12 erfolgt bei der Erfindung vorzugsweise im Bereich der Düse 23, d.h. also dort, wo eine hohe Genauigkeit gefordert wird.

Durch die Halterung der Stifte 15, 16 bzw. 35, 36 in dem Isolierblock 39 wird eine gute Wärmeisolierung der Düse 23 erreicht. In diesem Zusammenhang kommt der Tatsache Bedeutung zu, daß der einzige Kontakt zwischen den Stiften, die vorzugsweise aus Metall bestehen, und der Düse, die zweckmäßigerweise ebenfalls aus Metall besteht, immer innerhalb der Isolierhülle 24 erfolgt.

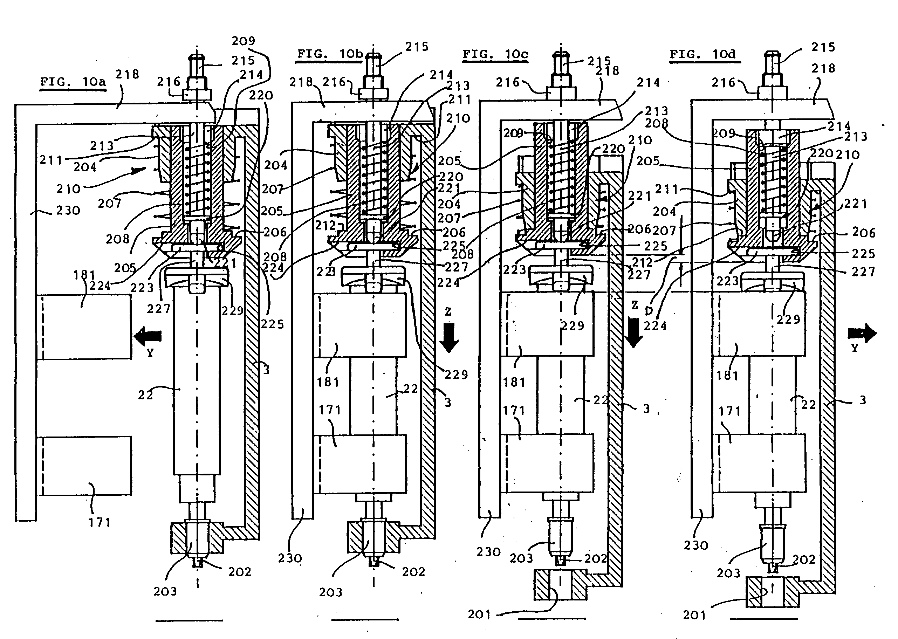

Im folgenden wird im Zusammenhang mit den Fig. 10a bis 10e, 11 und 12 eine Weiterbildung der Erfindung beschrieben, bei der die Entnahme einer Klebstoff-Kartusche 22 aus der Wartestation in den Dosierkopf 1 oder deren Abgabe aus dem Dosierkopf 1 in die Wartestation in einer einfacheren Weise dadurch möglich ist, daß der Dosierkopf 1 neben der Bewegung in der Z-Richtung nicht in den beiden Richtungen X und Y sondern nur in einer dieser Richtungen bewegt werden muß. Anders ausgedrück wird bei dieser Ausführungsform durch die Vorsehung eines speziellen Druckanschlußkopfes erreicht, daß die ohnehin zur Klebstoffabgabe auszuführende Bewegung in der Z-Richtung gleichzeitig auch zur Abgabe einer Kartusche in die Wartestation oder zur Entnahme einer Kartusche aus der Wartestation ausgenutzt wird. Das Anfahren der Wartestation wird dadurch wesentlich erleichtert.

Zum besseren Verständnis sind Einzelheiten der Fig. 10a bis 10e, 11 und 12, die bereits im Zusammenhang mit den Fig. 1 bis 9 beschrieben wurden, mit den entsprechenden Bezugszeichen versehen.

Der Dosierkopf 1 weist einen Hubschlitten 3 auf, der, wie dies bereits erläutert wurde, in der Z-Achse bewegbar ist. Am unteren Ende besitzt der Hubschlitten 3 eine in der Z-Achse verlaufende Aufnahmeöffnung 201 zur Aufnahme der Düse 202 der Kartusche 22 oder eines an dieser Düse 202 befestigten Abstandshalters 203. Der die Aufnahmeöffnung 201 umgebende Bereich kann auch als Klimakammer ausgebildet sein, deren Aufgabe darin besteht, den Klebstoff im Düsenbereich auf einer vorgegebenen Temperatur zu halten. Oberhalb der Aufnahmeöffnung 201 weist der Hubschlitten 3 den an einer Kartusche 22 lösbar ansetz- und verriegelbaren, Druckanschlußkopf 210 auf. Die Funktion dieses Druckanschlußkopfes 210 besteht im wesentlichen darin, gegen die Kraft eines ersten Energiespeichers eine Relativverschiebung in der Z-Achse zwischen einem ersten Element, das eine Aufnahmeeinrichtung für die der Düse 202 abgewandte, obere Seite der Kartusche 22 enthält, und einem am Hubschlitten 3 befestigten zweiten Element zu ermöglichen, wobei der Hubschlitten 3 die Aufnahmeöffnung 201 an seiner unteren Seite aufweist. Dadurch wird es möglich, die Aufnahmeöffnung 201 in der Z-Achse soweit nach unten zu verfahren, daß sie dann, wenn die Aufnahmeeinrichtung des ersten Elementes in der erforderlichen Weise zur Aufnahme eines Teiles der oberen Seite der Kartusche 22 in einer Richtung senkrecht zur Z-Richtung ausgerichtet ist, in der Y- (oder X-) Richtung unter die Düse 202 verschoben werden kann. Beim anschließenden Verfahren des Hubschlittens 3 nach oben, wird die Düse 202 durch die Kraft des Energiespeichers dann in die Aufnahmeöffnung 201 eingeführt. Die Kartusche 22 ist dann in dem Hubschlitten 3 gegen eine Relativbewegung in einer Richtung senkrecht zur Z-Richtung festgelegt.

Der Druckanschlußkopf 210 weist ein drittes Element auf, das gegen eine Bewegung in der Z-Richtung bei einer Kartuschenübergabefestlegbar ist, wobei das erste Element gegen die Kraft eines zweiten Energiespeichers in bezug auf das dritte Element in der Z-Richtung verschiebbar ist. Wenn das erste Element ein Teil der oberen Seite der Kartusche 22 aufnimmt, wird das dritte Element durch die Kraft des zweiten Energiespeichers in der Z-Richtung so gegen die Kartusche 22 gedrückt, daß es eine Verbindung zwischen dem Inneren der Kartusche 22 und einem mit ihm verbundenen Druckschlauch oder dgl. herstellt und daß es gleichzeitig für die Verriegelung des Druckanschlußkopfes 210 an der Kartusche 22 sowie für eine Zentrierung der Kartusche 22 in der Z-Richtung sorgen kann. Gegen die Kraft des weiteren Energiespeichers kann das erste Element relativ zum dritten Element soweit bewegt werden, daß seine Verbindung zur Kartusche zur Kartuschenabgabe oder -aufnahme gelöst wird.

Die Elemente und die Energiespeicher sind dabei so bemessen und angeordnet, daß bei einer Bewegung des Hubschlittens 3 in der Z-Richtung nach unten die Relativverschiebung zwischen dem ersten und dritten Element derjenigen zwischen dem zweiten und ersten Element nacheilt. Im wesentlichen besteht der bevorzugte Druckanschlußkopf 210 aus einer Haltehülse 204 (zweites Element), deren Achse zur Achse der Aufnahmeöffnung 201 ausgerichtet ist und die am oberen Ende des Hubschlittens 3 befestigt ist, einem in der Haltehülse 204 gehaltenen Galgenteil 205 (erstes Element), das in der Längsöffnung der Haltehülse 204 in axialer Richtung (Z-Achse) gleiten kann, einem äußeren Energiespeicher 207, der zwischen dem Galtenteil 205 und der Haltehülse 204 wirksam wird, und einem inneren Energiespeicher 208, der zwischen dem Galgenteil 205 und einem Anschlußteil 213 wirksam wird. Vorzugsweise weisen der äußere und der innere Energiespeicher die Form von Schraubenfedern 207, 208 auf. Die äußere Schraubenfeder 207 umgibt die Haltehülse 204 und das Galgenteil 205 und stützt sich einerseits an der Haltehülse 204 und andererseits an dem Galgenteil 205 ab. Zu diesem Zweck weist das Galgenteil 205 an seiner aus der Haltehülse 204 herausragenden, unteren Seite eine Anlageschulter 206 für die äußere Schraubenfeder 207 auf. In der entsprechenden Weise weist die Haltehülse 204 eine Anlageschulter 211 für die äußere Schraubenfeder 207 auf. Die äußere Schraubenfeder 207 versucht daher durch ihre Federkraft das Galgenteil 205 nach unten aus der Haltehülse 204 herauszudrücken.

An dem Galgenteil 205 ist ferner vorzugsweise eine Anschlagschulter 212 vorgesehen, an der die ihr zugewandten Endkante der Haltehülse 204 zur Anlage gelangt wenn die Haltehülse 204 gegen die Kraft der Feder 207 eine vorgegebene Strecke nach unten bewegt worden ist.

In der axial verlaufenden Längsöffnung 209 des Galgenteiles 205 befindet sich das rohrförmige Anschlußteil 213 (drittes Element), das von der inneren Schraubenfeder 208 umgeben ist. Das Anschlußteil 213 verläuft vorzugsweise durch die Bohrung eines Halteteiles 214, das in der Längsöffnung 209 angeordnet und fest mit dem Galgenteil 205 verbunden ist. Dabei kann das Anschlußteil 213 in der genannten Bohrung des Halteteiles 214 gleiten.

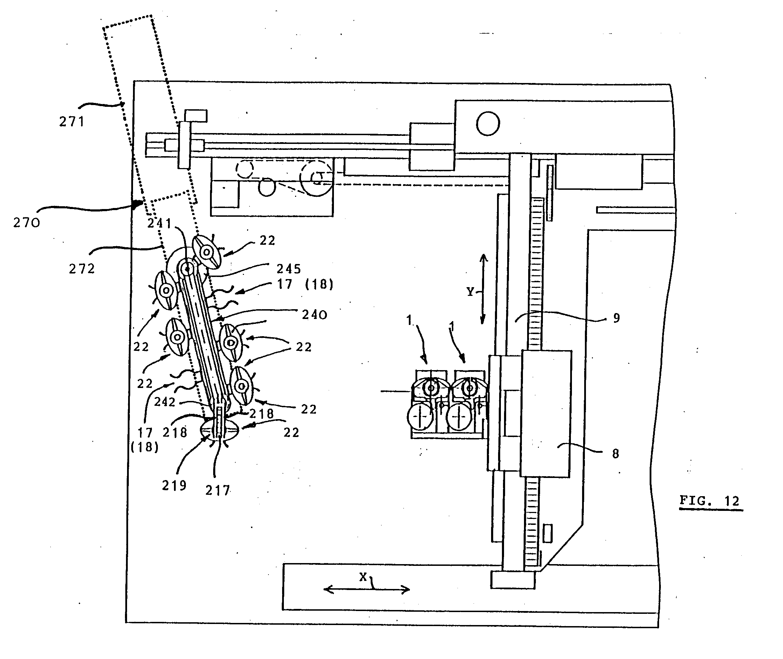

Das Halteteil 214 kann auch einstückig mit dem Galgenteil 205 ausgebildet sein. Das Anschlußteil 213 ragt nach oben über das Halteteil 214 hinaus und weist an seinem freien Ende einen Schlauchanschluß 215 auf, der mit einem nicht dargestellten Schlauch verbindbar ist, über den die Kartusche 22 mit Druckluft beaufschlagbar ist. Vom Halteteil 214 beabstandet weist das Anschlußteil 213 an seiner oberen Seite einen vorzugsweise ringförmigen Anschlag 216 auf, der fest mit dem Anschlußteil 213 verbunden ist, und dessen Umfang so bemessen ist, daß er über die gegenüberliegenden Randbereiche eines Spaltes 217 greifen kann, der zwischen den voneinander beabstandeten Gabelarmen 218 einer Haltegabel 219 der Wartestation liegt (Fig. 12). Auf diese Weise wird erreicht, daß der gesamte Druckanschlußkopf 210 mit einer daran befindlichen Kartusche 22 in der Richtung des Spaltes 217, d.h. also in der Y-Richtung, vom Dosierkopf 1 in die Haltegabel 219 eingeschoben werden kann und dort infolge der Auflage des ringförmigen Anschlages 216 an den Randbereichen des Spaltes 217 gegen eine Verschiebung in der Z-Achse nach unten festgehalten wird.

Die innere Schraubenfeder 208, die das Anschlußteil 213 umgibt, stützt sich einerseits an dem Halteteil 214 und andererseits an dem Anschlußteil 213 ab. Hierfür ist vorzugsweise ein ringförmiger Flansch 220 oder dgl. vorgesehen, der fest mit der Außenfläche des Anschlußteiles 213 an einem vom Halteteil 214 beabstandeten Ort verbunden ist. Dies bedeutet, daß die innere schraubenförmige Feder 208 im komprimierten Zustand versucht, das Galgenteil 205 in bezug auf das Anschlußteil 213 nach oben zu bewegen. Bei der Vorsehung eines separaten Halteteiles 214 kann dieses in dem Galgenteil 205 zur Einstellung der Vorspannung der Feder 208 verschraubbar angeordnet sein.

Das Anschlußteil 213 weist an seiner dem Schlauchanschluß 215 abgewandten Seite einen sich konisch verjungenden Zentrier- und Verriegelungsbereich 221 auf, der in die obere Öffnung 222 einer Kartusche 22 dicht einführbar ist (Fig. 12), wenn das nach unten bewegte Galgenteil 205 bei einer Bewegung des Hubschlittens 3 nach oben aufgrund der Federkraft der Feder 208 nach oben bewegt wird. Wenn der Bereich 221 in die Öffnung 222 eingreift, erfolgt eine Verriegelung der Kartusche 22 im Druckanschlußkopf 210 und eine Zentrierung der Kartusche 22 in bezug auf die Z- Richtung. Die Öffnung 222 befindet sich in einem Halteflansch 223 der Kartusche 22, der von einer Seite her, d.h. also z.B. in der Y-Richtung, in einen horizontalen Aufnahmeraum 224 einschiebbar ist, der sich in dem der Kartusche 22 zugewandten freien Endbereich des Galgenteiles 205 befindet. Die Öffnung 222 ist zum konischen Ende des Zentrierbereiches 221 ausgerichtet, wenn der Halteflansch 223 vollständig in den Aufnahmeraum 224 gegen einen Anschlag 225 eingeschoben ist. Der Aufnahmeraum 224 weist im Bereich des Anschlages 225 einen den Halteflansch 223 untergreifenden Bereich 226 (Fig. 10e) auf, durch den sichergestellt wird, daß der Halteflansch 222 nach dem vollständigen Einschieben in den Aufnahmeraum 224 bis zum Anschlag 225 im Aufnahmeraum 224 für eine Verschiebung mit dem Druckanschlußkopf 210 in der Z-Achse festgelegt ist. Der Halteflansch 223 ist vorzugsweise über ein Abstandsteil 227 mit einer Verschlußkappe 229 für die Kartusche 22 derart verbunden, daß der an der Öffnung 222 dicht anliegende Zentrierbereich 221 mit dem Innenraum der Kartusche 22 in Verbindung steht.

In der bereits beschriebenen Weise ist die Kartusche 22 in der Y-oder X-Richtung in Halterungen 17, 18 einschiebbar, die sich in der Wartestation befinden. Diese Halterungen 17, 18 bestehen vorzugsweise aus voneinander beabstandeten federnden Schenkeln 171 bzw. 181, die so ausgestaltet sind, daß die Kartusche 22 durch die Öffnung zwischen den freien Endbereichen der Schenkel 171 bzw. 181 einschiebbar ist und daß die Schenkel 171 bzw. 181 dann federnd an einem Teilbereich des Umfanges der Kartusche 22 anliegen. Vorzugsweise sind die Halterungen 17, 18 an einer Halteplatte 230 oder dgl. befestigt, die sich senkrecht zu den Gabelarmen 218 der Haltegabel 219 erstreckt.

Dabei ist dafür Sorge getragen, daß eine in die Halterungen 17, 18 eingeschobene Kartusche 22 um eine Strecke D (Fig. 10d) in der Z-Richtung absenkbar ist. Um diese Strecke D wird das Galgenteil 205 abgesenkt, um den Zentrier- und Verriegelungsbereich 221 aus der Öffnung 222 und dem Aufnahmeraum 224 zu entfernen.

Im folgenden wird nun die Funktion der zuvor beschriebenen Ausführungsformen näher erläutert. Dabei wird davon ausgegangen, daß in dem Hubschlitten 3 eine Kartusche 22 enthalten ist, wie dies Fig. 10a zeigt. In diesem Zustand sitzt die Düse 202 in der Öffnung 201 des Hubschlitten 3 und befindet sich der Halteflansch 223 der Kartusche 22 in dem Aufnahmeraum 224 derart, daß er am Anschlag 225 anliegt. Der Zentrierbereich 221 ist zur Öffnung 222 des Halteflansches 223 ausgerichtet. In diesem Zustand drückt die Feder 208, die sich an dem Halteteil 214 und an dem Flansch 220 abstützt, das Galgenteil 205 nach unten oben, so daß der konische Zentrierbereich 221 fest und dicht in die Öffnung 222 des Halteflansches 223 eingreift.

Der Hubschlitten 3 wird danach derart in der Y-Richtung bewegt, daß die Kartusche 22 in die Halterungen 17, 18 eingesetzt ist. In diesem Zustand befindet sich der ringförmige Anschlag 216 oberhalb der Gabelarme 218.

Gemäß Fig. 10b kann nun der Hubschlitten 3 in der Z-Richtung nach unten bewegt werden (Fig. 10b).

Wenn der Anschlag 216 an den Gabelarmen 218 aufliegt, wird zunächst die schwächere Feder 207 komprimiert, was zur Folge hat, daß die Haltehülse 204 gegen die Kraft der Feder 207 nach unten bewegt wird, bis ihr unterer Rand an dem Absatz 212 des Galgenteiles 205 anliegt. In diesem Zustand befindet sich die Düse 202 nicht mehr in der Öffnung 201 des Hubschlittens 3.

Wenn nun gemäß Fig. 10d der Hubschlitten 3 um eine kleine Entfernung D weiter in der Z-Richtung nach unten bewegt wird, wird aufgrund der Anlage der Haltehülse 204 an dem Galgenteil 205 die Feder 208 komprimiert, wobei sich das Galgenteil 205 soweit nach unten bewegt, bis der Zentrierbereich 221 die Öffnung 222 freigibt.

Es kann nun der Hubschlitten 3 in der Y-Richtung bewegt werden, bis der Halteflansch 223 nicht mehr in den Aufnahmeraum 224 eingreift (Fig. 10e). Anschließend kann der Hubschlitten 3 in der Z-Richtung angehoben werden, so daß der Anschlag 216 nicht mehr auf den Gabelarmen 218 aufliegt und sich die Federn 207, 208 entspannen können. Der gesamte Hubschlitten kann dann in der Y-Richtung von der Wartestation entfernt werden.

Die Entnahme einer Kartusche aus der Wartestation erfolgt in der umgekehrten Reihenfolge, wobei zunächst gemäß Fig. 10e der Hubschlitten 3 nach dem Einfahren zwischen die Gabelarme 218 soweit in der Z-Richtung abgesenkt wird, bis nach Anlage der Haltehülse 204 an dem Galgenteil 205 die Feder 208 soweit komprimiert wird, daß sich der Zentrierbereich 221 oberhalb der oberen Fläche des Halteflansches 223 mit der Öffnung 222 befindet. In dieser Position ist der die Aufnahmeöffnung 201 umgebende Bereich unterhalb der Düse 202 angeordnet, so daß der Hubschlitten 3 in der Y-Richtung soweit verfahren werden kann, bis der Halteflansch 223 am Anschlag 225 des Aufnahmeraumes 224 anliegt. Anschließend wird der Hubschlitten 3 soweit nach oben verfahren, bis die Düse 202 in der Aufnahemöffnung 201 angeordnet ist und der Zentrierbereich 221 dicht in die Öffnung 222 des Auflageflansches 223 eingreift. Der Hubschlitten 3 kann dann zusammen mit der Kartusche 22, die von der Halteeinrichtungen 17, 18 freigegeben wird, in der Y-Richtung aus der Wartestation entfernt werden.

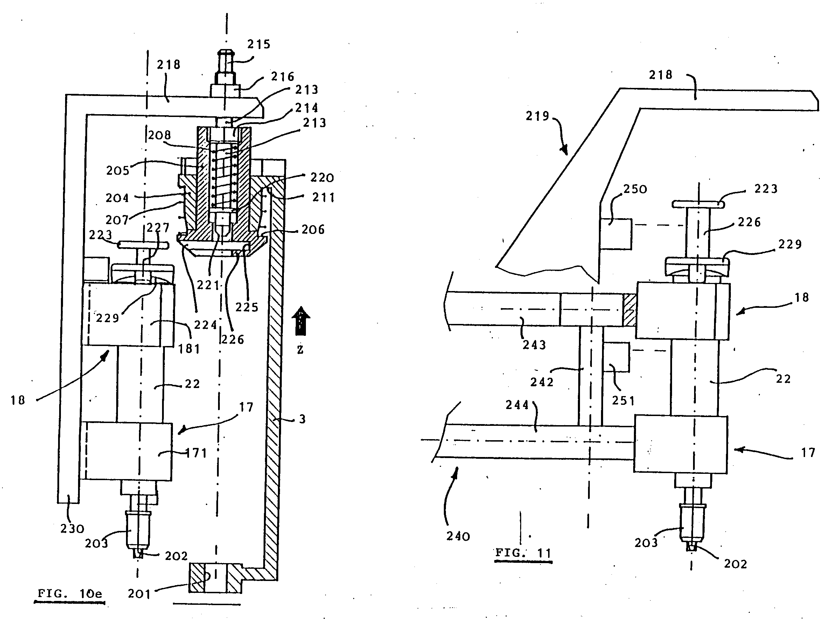

Gemäß den Fig. 11 und 12 kann die Wartestation so ausgebildet sein, daß die einzelnen Halterungen 17 und 18 in der Z-Richtung voneinander beabstandet an einer band- oder kettenartigen Fördereinrichtung 240 befestigt sind. Die Fördereinrichtung 240 verläuft um Umlenkrollen 241, 242, deren Achsen in der Z-Richtung ausgerichtet sind und von denen eine (241) vorzugsweise als eine Antriebsrolle ausgebildet ist. Vorzugsweise wird diese Antriebsrolle durch einen Elektromotor 245 angetrieben. Entlang der Länge der Fördereinrichtung 240 sind voneinander beabstandet mehrere Halterungen 17, 18 vorgesehen, so daß die Fördereinrichtung 240 eine Vielzahl von Kartuschen 22 fördern kann, die sich insbesondere im Hinblick auf ihre Düsengröße und die Art des in ihnen enthaltenen Klebstoffs voneinander unterscheiden können.

An einem vorgegebenen Ort befinden sich oberhalb der Fördereinrichtung 240 die durch den Spalt 217 voneinander getrennten Gabelarme 218 der Haltegabel 219, so daß bei einer gezielten Betätigung des Elektromotors 245 aufeinanderfolgend Halterungen 17, 18 unter die Gabelarme 218 verfahren werden können. Entsprechend der vorangehenden Beschreibung sind die Gabelarme 218 in der Y-Richtung ausgerichtet, so daß eine Kartusche 22 dadurch aus der Fördereinrichtung 240 der Wartestation entnommen werden kann oder an die Wartestation abgegeben werden kann, daß der Dosierkopf 1 mit dem Hubschlitten 3 in der Y-Richtung soweit verfahren wird, bis die Achse des Druckanschlußkopfes 210 zu der Achse der Halterungen 17, 18 ausgerichtet ist und daß dann durch einfaches Verfahren des Hubschlittens 3 in der Z-Richtung, wie dies oben erläutert wurde, das An- oder Abkoppeln des Druckanschlußkopfes 210 an die bzw. von einer Kartusche 22 erfolgt.

In der aus der Fig. 11 ersichtlichen Weise kann die Fördereinrichtung 240 zwei voneinander beabstandete Bänder 243, 244 aufweisen, wobei an jedem Band in der Z-Richtung zueinander ausgerichtet eine Halterung 17 bzw. 18 angeordnet ist.

In der Wartestation kann ein Sensor 250 im Bereich der Haltegabel 219 vorgesehen werden, der eine Codierung erfaßt, die z.B. die Düsengröße der gerade an dem Sensor 250 vorbeigeführten Kartusche 22 angibt. Beispielsweise spricht der Sensor 250 auf eine vorzugsweise an dem Abstandsteil 227 aufgebrachte Codierung an.

In der entsprechenden Weise kann im Bereich der Haltegabel 219 ein weiterer Sensor 251 vorgesehen sein, der ermittelt, ob die gerade an ihm vorbeigeführten Halterungen 17, 18 eine Kartusche 22 enthalten oder nicht. Bei diesem Sensor 251 kann es sich beispielsweise um ein fotoelektrisches Element handeln, das einen Lichtstrahl aussendet, der nur im Falle einer nicht vorhandenen Kartusche 22 zum Sensor 251 zurückreflektiert wird.

Gemäß der punktierten Darstellung der Fig. 12 kann die Fördereinrichtung 240 bewegbar bzw. verschiebbar oder auch verschwenk- bzw. verdrehbar angeordnet sein, so daß sie nach der Entnahme einer Kartusche 22 und vor dem Setzen von Klebstoffpunkten aus dem möglichen Arbeitsbereich des Dosierkopfes 1 bewegt werden kann.

Dadurch kann eine mögliche Behinderung bzw. Störung des Dosierkopfes 1 beim Setzen der Klebstoffpunkte durch die Fördereinrichtung 240 verhindert werden. Anders ausgedrückt kann dadurch der mögliche Arbeitsbereich des Dosierkopfes 1 vergrößert werden. Vorzugsweise ist die Fördereinrichtung 240 auf einer an sich bekannten Schlitteneinrichtung 270 zwischen der dargestellten ersten Position, in der die Entnahme/Abgabe einer Kartusche 22 unterhalb der Gabelarme 218 in der beschriebenen Weise möglich ist, und einer zweiten Position verfahrbar, in der die Fördereinrichtung 240 völlig aus dem möglichen Arbeitsbereich des Dosierkopfes 1 entfernt ist. Dabei erfolgt die Verfahrung der Schlitteneinrichtung 270 vorzugsweise in der Richtung der Längserstreckung der Fördereinrichtung 240 oder senkrecht dazu. Die Schlitteneinrichtung 270 weist zwei zweckmäßigerweise durch einen nicht dargestellten pneumatischen Antrieb gegeneinander verschiebbare Schlittenteile 271, 272 auf, wobei das eine Schlittenteil 271 an der zweiten Position ortsfest am Bestückungsautomaten und das andere Schlittenteil 272 an der Fördereinrichtung 240 befestigt sind.

## Patentansprüche

1. Einrichtung zum dosierten Auftragen von Klebstoff mit einer eine Klebstoff-Kartusche (22) und eine Düse (23) zur Abgabe von Klebstoff aus der Klebstoff-Kartusche (22) aufweisenden Dosiervorrichtung (10), wobei der Klebstoff in der Klebstoff-Kartusche (22) zur Abgabe einer vorgegebenen Klebstoffmenge aus der Düse (23) durch Druck beaufschlagbar ist und wobei die Dosiervorrichtung (10) durch einen durch einen Antrieb (2, 8, 9) bewegbaren Dosierkopf (1) zu vorgegebenen Orten oberhalb einer Leiterplatte (11) verfahrbar und in einen vorgegebenen Abstand zwischen der Austrittsöffnung (28) der Düse (23) und der Leiterplattenoberfläche bringbar ist,
**dadurch gekennzeichnet,** daß
a) eine Wartestation (12) vorgesehen ist, in der sich wenigstens eine Halteeinrichtung (13) befindet, in die die Dosiereinrichtung (10) lösbar einsetzbar ist, und daß
b) der Dosierkopf (1) eine Halteeinrichtung aufweist, die durch den Antrieb (2, 8, 9) zu der Halteeinrichtung (13) der Wartestation (12) derart verschiebbar ist, daß
c) eine Dosiervorrichtung (10) aus der angefahrenen Halteeinrichtung (13) der Wartestation (12) in die leere Halteeinrichtung des Dosierkopfes (1) übernehmbar ist und daß eine Dosiereinrichtung (10) aus der Halteeinrichtung des Dosierkopfes (1) in die angefahrene leere Halteeinrichtung der Wartestation (12) abgebbar ist.

2. Einrichtung nach Anspruch 1,
**dadurch gekennzeichnet,**
daß die Halteeinrichtung des Dosierkopfes (1) wenigstens eine die Kartusche (22) einer eingesetzten Dosiervorrichtung (10) aufnehmende Halterung (17, 18) aufweist.

3. Einrichtung nach Anspruch 2,
**dadurch gekennzeichnet,**
daß die Halterung(en) (17, 18) an einer senkrecht zur Leiterplattenoberfläche bewegbaren Hub- und Absenkeinrichtung des Dosierkopfes (1) angeordnet ist (sind).

4. Einrichtung nach Anspruch 3,
**dadurch gekennzeichnet,**
daß als Hub- und Absenkeinrichtung ein verschiebbar in dem Dosierkopf (1) angeordneter Hubschlitten (3) vorgesehen ist.

5. Einrichtung nach einem der Ansprüche 2 bis 4,
**dadurch gekennzeichnet,**
daß die Halterung(en) (17, 18) des Dosierkopfes (1) und/ oder die Halterung(en) (13) der Wartestation (12) voneinander beabstandete, federnde Schenkel (171, 181) aufweist (aufweisen), die die Kartusche (22) einer eingesetzten Dosiervorrichtung (10) wenigstens teilweise umschließen.

6. Einrichtung nach einem der Ansprüche 2 bis 5,
**dadurch gekennzeichnet,**
daß die Öffnungen zur Aufnahme und Entnahme der Halterung (en) der Wartestation (12) und des Dosierkopfes (1) aus um 90° gegeneinander versetzten Richtungen zugänglich sind.

7. Justiervorrichtung für eine Einrichtung nach einem der Ansprüche 1 bis 6,
**dadurch gekennzeichnet,**
daß die Düse (23) der Dosiervorrichtung (10) an ihrem Umfang eine Umfangsnut (30) aufweist, in die zwei voneinander beabstandete Stifte (15, 16) des Dosierkopfes (1) einführbar sind.

8. Justiervorrichtung nach Anspruch 7,
**dadurch gekennzeichnet,**
daß die Düse (23) der Dosiervorrichtung (10) an ihrem Umfang eine weitere Umfangsnut (36) aufweist, die gegenüber der Umfangsnut (3) in der Längsrichtung der Düse (23) versetzt ist und in die zwei voneinander beabstandete weitere Stifte (34, 35) einführbar sind, die jeweils einer Halteeinrichtung (13) der Wartestation (12) zugeordnet sind.

9. Temperiervorrichtung für eine Vorrichtung nach einem der Ansprüche 7 oder 8,
**dadurch gekennzeichnet,**
daß ein Stift (15) des Dosierkopfes (1) und/oder ein Stift (35) einer Halteeinrichtung (13) der Wartestation (12) einen in seiner Längsrichtung verlaufenden Hohlraum (37) aufweist, der sich am freien Ende des einen Stiftes (15 bzw. 35) in einen Raum (29) der Düse (23) öffnet, wenn die Düse (23) von den Stiften (15, 16) des Dosierkopfes (1) oder den Stiften (34, 35) der Halteeinrichtung (13) der Wartestation (12) aufgenommen wird,
daß der Raum (29) zwischen dem Umfang der Düse (23) und einer die Düse (23) umgebenden Isolierhülle (24) ausgebildet ist, daß die Isolierhülle (24) wenigstens eine Ausnehmung aufweist, durch die die Stifte (15, 16) des Dosierkopfes (1) und/oder eine weitere Ausnehmung aufweist,
durch die die Stifte (34, 35) der Halteeinrichtung (13) der Wartestation (12) hindurchführbar sind, und daß durch den Hohlraum (37) temperierte Luft in den Raum einführbar ist.

10. Vorrichtung nach einem der Ansprüche 8 oder 9,
**dadurch gekennzeichnet,**
daß sich die Stifte (15, 16) des Dosierkopfes (1) in einer Richtung erstrecken, die gegenüber der Richtung, in der sich die Stifte (34, 35) der Halteeinrichtung(en) (13) der Wartestation (12) erstrecken, um 90° versetzt ist.

11. Vorrichtung nach Anspruch 9 oder 10,
**dadurch gekennzeichnet,**
daß der jeweils andere Stift (16 bzw. 34) der Stifte (15, 16 bzw. 34, 35) des Dosierkopfes (1) und/oder der Halteeinrichtung(en) (13) der Wartestation (12) an seinem freien Ende einen Meßfühler (38) aufweist, der in dem Raum (29) angeordnet ist, wenn die Stifte (15, 16 bzw. 34, 35) in die Umfangsnut (30) bzw. in die weitere Umfangsnut (36) eingesetzt sind.

12. Vorrichtung nach einem der Ansprüche 7 bis 11,
**dadurch gekennzeichnet,**
daß von den freien Enden abgewandte Bereiche der Stifte (15, 16) des Dosierkopfes (1) und/oder der Stifte (34, 35) der Halteeinrichtung(en) (13) der Wartestation (12) in einen Isolierblock (39) eingebettet sind, der von dem Dosierkopf (1) bzw. von einem Teil (33) der Wartestation (12) gehalten wird.

13. Vorrichtung nach einem der Ansprüche 7 bis 12,
**dadurch gekennzeichnet,**
daß die Düse (23) durch eine Stütz- oder Schraubverbindung (50) an der Kartusche (22) befestigbar ist.

14. Vorrichtung nach einem der Ansprüche 7 bis 13,
**dadurch gekennzeichnet,**
daß die Düse (23) einen einen Abgabestutzen (51) der Kartusche (22) dicht aufnehmenden Innenhohlraum (52) aufweist, der im Bereich zwischen dem Ende des Abgabestutzens (51) und der Abgabeöffnung (28) eine konische Verjüngung aufweist.

15. Einrichtung nach Anspruch 3,
**dadurch gekennzeichnet,**
daß an der Hub- und Absenkeinrichtung des Dosierkopfes (1) ein Druckanschlußkopf (210) befestigt ist, der bei seiner Bewegung in der Hub- und Absenkeinrichtung eine Kartusche (22) lösbar derart aufnehmen kann, daß eine Verbindung vom Inneren der Kartusche (22) zu einem Druckanschluß (215) des Druckanschlußkopfes (210) herstellbar ist.

16. Einrichtung nach den Ansprüchen 4 und 15,
**dadurch gekennzeichnet,**
daß an einer Seite des Hubschlittens (3) der Druckanschlußkopf (210) und an der anderen Seite des Hubschlittens (3) eine Aufnahmeöffnung (201) für die Aufnahme eines unteren Bereiches der Kartusche (22) vorgesehen sind, und daß der Druckanschlußkopf (210) einen Teil des oberen Bereiches der Kartusche (22) derart aufnehmen kann, daß die Kartusche (22) zur Aufnahmeöffnung (201) ausgerichtet ist.

## Claims

1. Apparatus for the dosed application of adhesive, having a dosing device (10) exhibiting an adhesive cartridge (22) and a nozzle (23) for dispensing adhesive from the adhesive cartridge (22), the adhesive in the adhesive cartridge (22) being able to be pressurised for dispensing a predetermined amount of adhesive from the nozzle (23) and the dozing device (10) being able to travel by means of a dosing head (1), which can move by means of a drive (2, 8, 9), to predetermined locations above a circuit board (11) and be brought to a predetermined distance between the outlet opening (28) of the nozzle (23) and the surface of the circuit board, characterised in that
a) a waiting station (12) is provided, in which there is located at least one holding device (13) into which the dosing device (10) can be releasably inserted, and in that
b) the dozing head (1) exhibits a holding device which can be displaced by means of the drive (2, 8, 9) with respect to the holding device (13) of the waiting station (12) in such a way that
c) a dozing device (10) can be transferred out of the brought-up, holding device (13) of the waiting station (12) into the empty holding device of the dozing head (1) and in that a dozing device (10) can be discharged out of the holding device of the dozing head (1) into the brought-up, empty holding device of the waiting station (12).

2. Apparatus according to Claim 1, characterised in that the holding device of the dozing head (1) exhibits at least one holder (17, 18) receiving the cartridge (22) of an inserted dosing device (10).

3. Apparatus according to Claim 2, characterised in that the holder(s) (17, 18) is(are) arranged on a lifting and lowering device of the dozing head (1) in such a way as to be movable perpendicularly with respect to the surface of the circuit board.

4. Apparatus according to Claim 3, characterised in that a lifting carriage (3) arranged displaceably in the dosing head (1) is provided as the lifting and lowering device.

5. Apparatus according to one of Claims 2 to 4, characterized in that the holder(s) (17, 18) of the dozing head (1) and/or the holder(s) (13) of the waiting station (12) exhibit(s) spaced-apart, resilient legs (171, 181), which at least partially enclose the cartridge (22) of an inserted dozing device (10).

6. Apparatus according to one of Claims 2 to 5, characterised in that the openings for receiving and removing the holder(s) of the waiting station (12) and of the dosing head (1) are accessible from directions mutually offset by 90°.

7. Adjusting device for an apparatus according to one of Claims 1 to 6, characterised in that the nozzle (23) of the dozing device (10) exhibits on its circumference a circumferential groove (30), into which two spaced-apart pins (15, 16) of the dosing head (1) can be introduced.

8. Adjusting device according to Claim 7, characterized in that the nozzle (23) of the dozing device (10) exhibits on its circumference a further circumferential groove (36), which is offset in comparison with the circumferential groove (36) in the longitudinal direction of the nozzle (23) and into which two spaced-apart further pins (34, 35), which are in each case assigned to a holding device (13) of the waiting station (12), can be introduced.

9. Temperature-controlling device for a device according to one of Claims 7 or 8, characterised in that a pin (15) of the dozing head (1) and/or a pin (35) of a holding device (13) of the waiting station (12) exhibits a hollow space (37) which runs in its longitudinal direction and, at the free end of the one pin (15 or 35), opens into a space (29) of the nozzle (23) when the nozzle (23) is received by the pins (15, 16) of the dozing head (1) or the pins (34, 35) of the holding device (13) of the waiting station (12), in that the space (29) is formed between the circumference of the nozzle (23) and an insulating sleeve (24) surrounding the nozzle (23), in that the insulating sleeve (24) exhibits at least one clearance, through which the pins (15, 16) of the dosing head (1) can be passed and/or a further clearance, through which the pins (34, 35) of the holding device (13) of the waiting station (12) can be passed, and in that air of which the temperature has been controlled by the hollow space (37) can be introduced into the space.

10. Device according to one of Claims 8 or 9, characterised in that the pins (15, 16) of the dosing head (1) extend in a direction which is offset by 90° in comparison with the direction in which the pins (34, 35) of the holding device(s) (13) of the waiting station (12) extend.

11. Device according to Claim 9 or 10, characterised in that the respectively other pin (16 or 34) of the pins (15, 16 and 34, 35) of the dosing head (1) and/or of the holding device(s) (13) of the waiting station (12) exhibits at its free end a measuring sensor (38) which is arranged in the space (29) when the pins (15, 16 and 34, 35) are respectively inserted in the circumferential groove (30) or in the further circumferential groove (36).

12. Device according to one of Claims 7 to 11, characterised in that regions remote from the free ends of the pins (15, 16) of the dozing head (1) and/or of the pins (34, 35) of the holding device(s) (13) of the waiting station (12) are embedded in an insulating block (39) which is held respectively by the dosing head (1) or by a part (33) of the waiting station (12).

13. Device according to one of Claims 7 to 12, characterised in that the nozzle (23) can be fixed on the cartridge (22) by means of a supporting or screwing connection (50).

14. Device according to one of Claims 7 to 13, characterised in that the nozzle (23) exhibits an inner hollow space (52) which tightly receives a discharging stub (51) of the cartridge (22) and exhibits a conical taper in the region between the end of the discharging stub (51) and the discharging opening (28).

15. Apparatus according to Claim 3, characterised in that on the lifting and lowering device of the dosing head (1) there is fastened a pressure connection head (210) which, during its movement in the lifting and lowering device, can releasably receive a cartridge (22) in such a way that a connection from the inside of the cartridge (22) to a pressure connection (215) of the pressure connection head (210) can be established.

16. Apparatus according to Claims 4 and 15, characterised in that on one side of the lifting carriage (3) of the pressure connection head (210) and on the other side of the lifting carriage (3) there is provided a receiving opening (201) for receiving a lower region of the cartridge (22), and in that the pressure connection head (210) can receive a part of the upper region of the cartridge (22) in such a way that the cartridge (22) is aligned with respect to the receiving opening (201).

## Revendications

1. Dispositif pour l'application dosée d'une colle, comportant un dispositif de dosage (10) équipé d'une cartouche de colle (22) et d'une buse (23) servant à refouler la colle hors de la cartouche de colle (22), et dans lequel la colle située dans la cartouche de colle (22) peut être chargée par une pression pour permettre la distribution d'une quantité prédéterminée de colle par la buse (23), et dans lequel le dispositif de dosage (10) peut être déplacé au moyen d'une tête de dosage (1), déplaçable au moyen d'un dispositif d'entraînement (2,8,9), jusqu'à des emplacements prédéterminés au-dessus d'une plaquette à circuits imprimés (11), et peut être amené à une distance prédéterminée entre l'ouverture de sortie (28) de la buse (23) et la surface de la plaquette à circuits imprimés,
caractérisé par le fait que
a) il est prévu un poste d'attente (12), dans lequel est situé au moins un dispositif de retenue (13), dans lequel le dispositif de dosage (10) peut être inséré de façon amovible, et que
b) la tête de dosage (1) possède un dispositif de retenue, qui est déplaçable au moyen du dispositif d'entraînement (2,8,9) en direction du dispositif de retenue (13) du poste d'attente (12) de telle sorte que
c) un dispositif de dosage (10) peut être transféré du dispositif de retenue approché (13) du poste d'attente (12) dans le dispositif de retenue vide de la tête de dosage (1) et qu'un dispositif de dosage (10) peut être sorti du dispositif de retenue de la tête de dosage (1) pour être introduite dans le dispositif de retenue vide approché, du poste d'attente (12).

2. Dispositif suivant la revendication 1, caractérisé en ce que le dispositif de retenue de la tête de dosage (1) possède au moins un support (17,18), qui loge la cartouche (22) d'un dispositif de dosage (10) introduit.

3. Dispositif suivant la revendication 2, caractérisé par le fait que le ou les dispositifs de retenue (17,18) est (sont) disposé(s) sur un dispositif de soulèvement et d'abaissement de la tête de dosage (1), qui est déplaçable perpendiculairement à la surface de la plaquette à circuits imprimés.

4. Dispositif suivant la revendication 3, caractérisé par le fait qu'il est prévu, comme dispositif de soulèvement et d'abaissement, un chariot de levage (3) monté de manière à être déplaçable dans la tête de dosage (1).

5. Dispositif suivant l'une des revendications 2 à 4, caractérisé par le fait que le ou les supports (17,18) de la tête de dosage (1) et/ou le ou les supports (13) du poste d'attente (12) comporte ou comportent des branches élastiques (171,181) distantes l'une de l'autre et qui enserrent au moins partiellement la cartouche (22) d'un dispositif de dosage (10) introduit.

6. Dispositif suivant l'une des revendications 2 à 5, caractérisé par le fait que les ouvertures pour le logement et le prélèvement du ou des dispositifs de support du poste d'attente (12) et de la tête de dosage (1) sont accessibles à partir de directions décalées réciproquement de 90°.

7. Dispositif d'ajustement pour un dispositif suivant l'une des revendications 1 à 6, caractérisé par le fait que la buse (23) du dispositif de dosage (10) possède, sur son pourtour, une gorge circonférentielle (30), dans laquelle peuvent être insérées deux broches (15,16) de la tête de dosage (1), qui sont distantes l'une de l'autre.

8. Dispositiv d'ajustement suivant la revendication 7, caractérisé par le fait que la buse (23) du dispositif de dosage (10) comprend, sur son pourtour, une autre gorge circonférentielle (36), qui est décalée par rapport à la gorge circonférentielle (36), dans la direction longitudinale de la buse (23), et dans laquelle peuvent être insérées deux autres broches (34,35), qui sont distantes l'une de l'autre et qui sont associées respectivement à un dispositif de retenue (13) du poste d'attente (12).

9. Dispositif de mise en température pour un dispositif suivant l'une des revendications 7 ou 8, caractérisé par le fait qu'une broche (15) de la tête de dosage (1) et/ou une broche (35) d'un dispositif de retenue (35) du poste d'attente (12) possède une cavité (37) qui s'étend dans la direction longitudinale de la tige et débouche, à l'extrémité libre d'une tige (15 ou 35), dans un espace (29) de la buse (23) lorsque cette dernière est reçue par les broches (15,16) de la tête de dosage (1) ou par les broches (34,35) du dispositif de retenue (13) du poste d'attente (12),
que l'espace (29) présent entre le pourtour de ta buse (23) et une gaine isolante (24) entourant la buse (23), est agencé de telle sorte que ta gaine isolante (23) possède au moins un évidement, que peuvent traverser tes broches (15,16) de la tête de dosage (1), et/ou un autre évidement, que peuvent traverser les broches (34,35) du dispositif de retenue (13) du poste d'attente (12), et que de l'air mis en température peut être introduit dans l'espace, par la cavité (37).

10. Dispositif suivant l'une des revendications 8 ou 9, caractérisé par le fait que les broches (15,16) de la tête de dosage (1) s'étendent dans une direction qui est décalée de 90° par rapport à la direction dans laquelle s'étendent tes broches (35) du ou des dispositifs de retenue (13) du poste d'attente (12).

11. Dispositif suivant la revendication 9 ou 10, caractérisé par le fait que l'autre (16 ou 34) des broches (15, 16 ou 34, 35) de ta tête de dosage (1) et/ou du ou des dispositifs de retenue (13) du poste d'attente (12) possède, sur son extrémité libre, un capteur de mesure (38), qui est disposé dans l'espace (29) lorsque tes broches (15, 16 ou 34, 35) sont insérées dans la gorge circonférentielle (30) ou dans l'autre gorge circonférentiette (36).

12. Dispositif suivant l'une des revendications 7 à 11, caractérisé par te fait que des parties, tournées à l'opposé des extrémités libres, des broches (15,16) de ta tête de dosage (1) et/ou des broches (34,35) du ou des dispositifs de retenue (13) du poste d'attente (12) sont insérées dans un bloc isolant (39), qui est maintenu par la tête de dosage (1) ou par une partie (33) du poste d'attente (12).

13. Dispositif suivant l'une des revendications 7 à 12, caractérisé par te fait que la buse (23) peut être fixée à la cartouche (22) par l'intermédiaire d'une liaison de support ou à vis (50).

14. Dispositif suivant l'une des revendications 7 à 13, caractérisé par te fait que la buse (23) possède une cavité intérieure (52), qui loge étroitement une tubulure de sortie (51) de la cartouche (22) et possède une forme rétrécie conique dans la zone comprise entre l'extrémité de la tubulure de sortie (50) et t'ouverture de sortie (28).

15. Dispositif suivant la revendication 3, caractérisé par le fait que sur le dispositif de soulèvement et d'abaissement de la tête de dosage (1) est fixée une tête (210) de raccordement de la pression, qui peut recevoir de façon amovible une cartouche (22) lors de son déplacement dans le dispositif de soulèvement et d'abaissement, de sorte qu'une liaison peut être établie entre l'intérieur de ta cartouche (22) et un raccord de pression (215) de ta tête (210) de raccordement de la pression.

16. Dispositif suivant l'une des revendications 4 et 15, caractérisé par te fait que sur un côté du chariot de déplacement (3) de la tête (210) de raccordement de ta pression et sur t'autre côté du chariot (803), il est prévu une ouverture de logement (201) servant à loger une partie inférieure de ta cartouche (22), et que ta tête (210) de raccordement de la pression peut recevoir une partie de la zone supérieure de ta cartouche (22), de telle sorte que la cartouche (22) est alignée sur l'ouverture de logement (201).
